(19) Europäisches Patentamt
European Patent Office
Office européen des brevets

(11) Publication number: 0 190 831 A2

# (12) EUROPEAN PATENT APPLICATION

(21) Application number: 86300269.7

(22) Date of filing: 16.01.86

(51) Int. Cl.⁴: C 08 G 75/04
G 03 C 1/08

(30) Priority: 04.02.85 US 697617

(43) Date of publication of application: 13.08.86 Bulletin 86/33

(84) Designated Contracting States: DE FR GB

(71) Applicant: LOCTITE (IRELAND) Ltd.
Whitestown Industrial Estate
Tallaght, Co. Dublin(IE)

(72) Inventor: Woods, John
138 Stillorgan Wood Upper Kilmacud Road
Stillorgan County Dublin(IE)

(72) Inventor: Steinkraus, Walter J.
117 Parkview Drive
Avon Connecticut 06001(US)

(72) Inventor: Rooney, John M.
76 The Paddocks
Naas Co. Kildare(IE)

(74) Representative: Marchant, James Ian et al,
Elkington and Fife High Holborn House 52/54 High Holborn
London WC1V 6SH(GB)

## (54) Photocationically curable thiol-ene compositions.

(57) A composition curable to a cross-linked solid polymer with UV irradiation comprising a) a polythiol compound having at least 2 thiol groups per molecule; b) an 'ene compound having at least one vinyl cycloacetal group selected from the formulas:

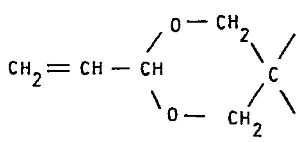

and

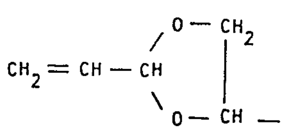

;

and c) a cationic photoinitiator.

The compositions cure in seconds or minutes at ambient temperatures in conventional UV ovens to crosslinked solids with enhanced properties over comparable formulations employing radical photoinitiators.

EP 0 190 831 A2

0190831



# Photocationically Curable Thiol-ene Compositions

## Background of The Invention

In U.S. 3,661,744 there are described compositions of polythiol resins and certain polyenes which cure by radical initiated addition reactions between the two functionalities. The reaction requires that the sum of thiol functionality/polythiol molecule plus ene functionality/polyene molecule be in excess of 4 in order to cure to a solid cross-linked resin.

In U.S. Patents 4,119,617, 4,157,421 and 4,182,848 there are described radically photocurable compositions comprise polythiols and a polyene derived from a vinyl acetal. These polyenes have two or more unsaturated cycloacetal groups per molecule expressed by the formula

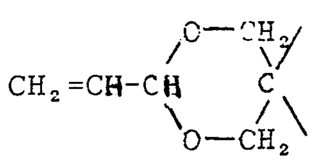 or 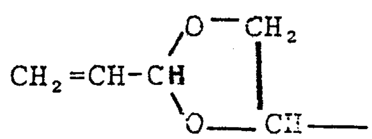

In all of the above references the compositions cured by photochemical processes are known radical processes, either by direct radical generation with high intensity radiation or with radical photoinitiators such as benzophenone.

U.S. 4,119,617 also discloses that such resin mixtures can be cured with a strong acid initiator but the exemplified cure times are slow and include elevated temperatures or a post cure bake.

## Summary of The Invention

The present inventors have discovered that compositions of polythiols and vinyl cycloacetal polyenes of the type described in U.S. Patents 4,119,617, 4,157,421, and 4,182,848 can be readily cured with UV cationic photoinitiators. The new compositions unlike the acid cured compositions of U.S. 4,119,617 cure to solids within seconds or minutes at ambient temperatures in conventional UV ovens. Also, surprisingly, they give enhanced cured properties over compaparableformulations using radical photoinitiators. The composition readily cure even where the total functionality of ene and thiol is as low as 4 or slightly less.

## Detailed Description of The Invention

The vinyl cycloacetal resins useful in the invention are compounds having an average of more than 1 group, preferably 2 or more groups, of the formula

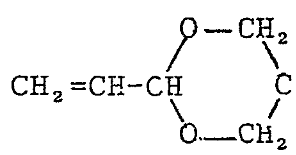

or

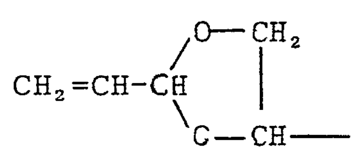

per molecule. Suitable examples include 3,9-divinyl-2,4,8,10-tetraoxaspiro[5.5] Undecane (DTU) also known as diallylidene pentaerythritol, triallylidene sorbitol, diallylidene 2,2,66-tetramethylol cyclohexanone and reaction products of polyisocyanate resins with 5-ethyl-5-hydroxymethyl-2-vinyl-m-dioxane, 4-hydroxymethyl-2-vinyl-1,3-dioxolane or 5-hydroxy-2-vinyl-m-dioxane. Other examples of suitable vinyl cycloacetal resins are contained in U.S. Patent 4,119,617 at columns 4-7 and U.S. 4,157,421, columns 2-4.

The polythiol resins useful in the inventive compositions are also described in the aforementioned patents, specifically in column 7 of U.S. 4,119,617 and column 4 of U.S. 4,157,421. Further examples

may be found in U.S. 3,661,744 at columns 8-9. Preferred polythiol resins include pentaerythritol tetrakis (β-mercaptoproprionate) (PTM), pentaerythitrol tetrakis (mercapto acetate), trimethylolpropane trimercaptoacetate and di-(2-mercapto) ethyl ether.

Cationic photoinitiators are well known materials. Usually they are complex salts of certain specified cations and weak nucleophile anions. Examples include aryl diazonium salts, Group VIa aromatic onium salts, Group Va aromatic onium salts, diaryl iodonium salts, sulfonium salts, pyrylium salts, alkyl aryl iodonium salts and thiopyrylium salts, of such anions as tetrafluoroarsenate, hexafluorophosphate, hexafluoroantimonate, etc. Such salts are disclosed in U.S. Patents 3,708,296; 4,058,401; 4,069,056; 4,090,936; 4,383,025; 4,398,014; 4,405,765; and 4,450,360, respectively. Of these various cationic photoinitiators iodonium, sulfonium and pyrylium salts are generally preferred. Diazonium salts should generally be avoided because of their poor stability.

The ratios of polythiol and cyclic vinyl acetal resins in the inventive composition are not critical. However, for optional properties, it will generally be preferred that the ratio of equivalent of thiol groups to cyclic vinyl acetal groups be in the range of 30:70 to 70:30, most preferably approximately 50:50. The cationic photoinitiator may be employed in the compositions at levels of between about 0.1 and 10% by weight of the total composition, preferably between 1% and 5%.

The invention is illustrated by the following

nonlimiting examples.

Example 1

A series of formulations were prepared based on mixtures of 80 parts of 3,9-vinyl-2,4,8,10-tetra-oxaspiro[5.5] undecane (DTU) and 20 parts of dibutyl phthalate (DBP) added to plasticize the solid DTU. This mixture will be referred to as composition X.

Formulation A was prepared by adding to 100 parts of composition X 3 parts of a commercially available cationic photoinitiator, UVE-1014 (General Electric Co.), and 2 parts of an amine, ethyl-4-dimethylaminobenzoate (EPD). Formulation B was prepared by adding to 100 parts of composition X 3 parts of UVE-1014 and 2 parts of tributyl amine (TBA). Formulation C was prepared by adding to 100 parts of composition X 3 parts of UVE-1014. Formulation D is composition X with no additives. Formulation E was prepared by adding to 100 parts of composition X 2 parts of 2,2-dimethoxy-2-phenylacetophenone, a free radical photoinitiator (DMPA).

All formulations were coated onto glass slides and irradiated under a medium-pressure mercury lamp with a power rating of 200 watts per linear inch at an intensity of 100 milliwatts/sq. cm. at 365mm. The time taken to produce an insoluble film was measured and the results are listed in Table 1.

TABLE 1

| Formulation | A | B | C | D | E |
|---|---|---|---|---|---|
| DTU | 80 | 80 | 80 | 80 | 80 |
| DBP | 20 | 20 | 20 | 20 | 20 |
| UVE-1014 | 3 | 3 | 3 | - | - |
| EPD | 2 | - | - | - | - |
| TBA | - | 2 | - | - | - |

| | A | B | C | D | E |
|---|---|---|---|---|---|
| DMPA | - | - | - | - | 2 |
| Time, sec. | 30 | 30 | 15-30 | 30 | 30 |

The results show that amines retard the polymerization of DTU in the presence of a cationic photoinitiator, while in the absence of such a photoinitiator or in the presence of a free-radical photoinitiator the polymerization is also retarded. Thus cationic propagation or cross-linking of DTU in the presence of cationic photoinitiators is demonstrated.

Example 2

A series of formulations were prepared. Formulation A consisted of 24.4 grams of pentaerythritol tetrakis (β-mercaptopropionate) (PTM), 16.6 grams of triallyl-s-triazine trione (TST) and 1.23 grams of UVE-1014. Formulation B consisted of 24.4 grams of PTM, 16.6 grams of TST and 0.62 grams of DMPA. Formulation C consisted of 24.4 grams of PTM, 21.2 grams of DTU and 1.37 grams of UVE-1014. Formulation D consisted of 24.4 grams of PTM, 21.2 grams of DTU and 0.68 grams of DMPA. All formulations were filled into molds 8mm in diameter and 2mm in depth and irradiated under a medium-pressure mercury lamp with a power rating of 200 watts per linear inch at an intensity of 80 milliwatts/sq. cm. at 365mm for 30 seconds. The cured slugs of material were removed from the molds and tested for Barber Coleman hardness with the results listed in Table 2.

TABLE 2

| Formulation | A | B | C | D |
|---|---|---|---|---|
| PTM | 24.4 | 24.4 | 24.4 | 24.4 |
| TST | 16.6 | 16.6 | - | - |
| DTU | - | - | 21.2 | 21.2 |
| UVE-1014 | 1.23 | - | 1.37 | - |
| DMPA | - | 0.62 | - | 0.68 |
| Hardness | 0 | 14 | 17 | 17 |

These results show that the presence of vinyl cycloacetal monomer is essential to the development of useful material properties in the presence of a cationic photoinitiator.

Example 3

Two formulations were prepared. Formulation A consisted of 2.44 grams of PTM, 1.66 grams of TST, 0.03 grams of 2,4,6, triphenyl pyrylium hexafluoroantimonate (TPHA), 0.02 grams of 2,6-di-tert-butyl-4-methylphenol (DTBM), and 0.40 grams of propylene carbonate (PC). Formulation B consisted of 2.44 grams of PTM, 2.12 grams of DTU, 0.04 grams of TPHA, 0.023 grams of DTBM and 0.40 grams of PC.

Both formulations were filled into molds 8mm in diameter and 2mm in depth and irradiated under a medium-pressure mercury lamp at an intensity of 100 milliwatts/sq. cm. at 365mm for 300 seconds. At the end of this time the irradiated slugs of material were removed from the molds and extracted with acetone at room temperature for 30 seconds, dried and weighed. The material from Formulation A was only 14% insoluble while the material from Formulation B was 93% insoluble,

again demonstrating the necessity of incorporating a vinyl cycloacetal monomer into thiol-ene formulations containing a cationic photoinitiator. The 93% insoluble result for Formulation B also demonstrates that the polythiol resin is incorporated into the cured polymer.

Example 4

Two formulations were prepared. Formulation A consisted of 1.38 grams of 2-mercaptoethyl ether, 2.12 grams of DTU, and 0.11 grams of UVE-1014. Formulation B consisted of 1.38 grams of 2-mercaptoethyl ether, 2.12 grams of DTU, and 0.04 grams of DMPA. Since both resins are difunctional the total functionality of the system, as described above, was only 4. Films of both compositions were placed between assemblies comprising a sheet of 3" X 3" X 3/4" safety glass and a 1" diameter hexagonal aluminium bolt head 1/2" in thickness.

The films were irradiated through the safety glass under a medium-pressure mercury lamp with a power rating of 200 watts per linear inch at an intensity of 80 milliwatts/sq. cm. at 365mm for 120 seconds. At the end of this time a torque wrench was applied to the hexagonal bolt head and the torque required to remove the bolt head from the glass was measured. The assembly incorporating Formulation A required a torque of 100 kg-cm while the assembly incorporating Formulation B required only 30 kg-cm.

CLAIMS

1. A composition curable to a cross-linked solid polymer with UV irradiation comprising a) a polythiol compound having at least 2 thiol groups per molecule; b) an 'ene compound having at least one vinyl cycloacetal group selected from the formulas:

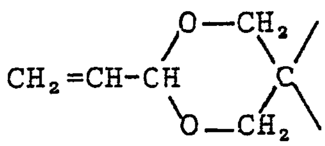 and 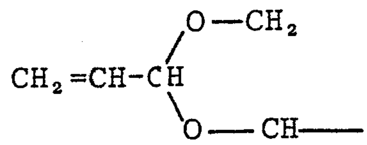

and c) a cationic photoinitiator.

2. A composition as in Claim 1 wherein the sum of thiol groups per polythiol molecule and vinyl cycloacetal groups per 'ene compound molecule does not exceed 4.

3. A composition as in Claim 1 wherein the cationic photoinitiator is selected from group Va aromatic onium salts, group VIa aromatic onium salts, diaryl iodonium salts, alkyl aryl iodonium salts, pyrylium salts, sulfoxonium salts, and thiopyrylium salts of weak nucleophile anions.

4. A compositions as in Claim 3 wherein the cationic photoinitiator is selected from aromatic sulfonium salts, aromatic iodonium salts and pyrylium salts.

5. The composition of Claim 1 wherein the polythiol resin is selected from pentaerythritol tetrakis (β-mercaptoproprionate), pentaerythritol tetrakis (Mercaptoacetate), trimethylolpropane trimercaptoacetate and di-(2-mercapto)ethyl ether.

6. The composition of Claim 1 wherein the photoinitiator is present in the range of .1%-10% by weight of the composition.

7. The composition of claim 6 wherein the photoinitiator is present in the range of 1%-5% by weight of the composition.

8. The composition of Claim 1 wherein the 'ene compound is 3,9-divinyl-2,4,8,10-tetraoxaspiro-[5,5] undecane.

9. The composition of Claim 8 wherein the polythiol resin is di-(2-mercapto) ethyl ether.

10. The composition of Claim 1 wherein the ratio of thiol groups to cyclic vinyl groups is in the range of 30:70 to 70:30.

11. A composition as in Claim 1 wherein said 'ene compound has at least 2 said vinyl cycloacetal groups per molecule.

12. In a method of curing a composition comprising a polythiol; a compound having at least one vinyl cycloacetal group selected from the formulas:

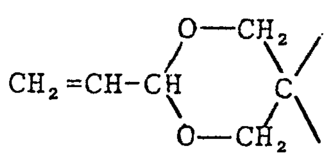

and

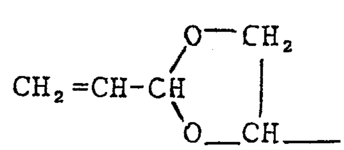

and a photoinitiator, the method comprising exposing the composition to actinic radiation, the improvement comprising that said photoinitiator is a cationic photoinitiator.